(19) Europäisches Patentamt
European Patent Office
Office européen des brevets

(11) **EP 4 440 136 A1**

(12) **DEMANDE DE BREVET EUROPEEN**

(43) Date de publication:
**02.10.2024 Bulletin 2024/40**

(21) Numéro de dépôt: **24165291.6**

(22) Date de dépôt: **21.03.2024**

(51) Classification Internationale des Brevets (IPC):
**H04N 25/63** (2023.01)   **H04N 25/65** (2023.01)
**H04N 25/77** (2023.01)   **H04N 25/771** (2023.01)

(52) Classification Coopérative des Brevets (CPC):
**H04N 25/65; H04N 25/671; H04N 25/77;**
H04N 25/771

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **30.03.2023 FR 2303104**

(71) Demandeur: **STMICROELECTRONICS (GRENOBLE 2) SAS**
**38000 Grenoble (FR)**

(72) Inventeur: **SIMONY, Laurent**
**38100 GRENOBLE (FR)**

(74) Mandataire: **Cabinet Beaumont**
**4, Place Robert Schuman**
**B.P. 1529**
**38025 Grenoble Cedex 1 (FR)**

(54) **CIRCUIT ELECTRONIQUE D'ACQUISITION D'IMAGE**

(57)    La présente description concerne un circuit électronique comprenant des cellules (210) d'acquisition d'image, chaque cellule comportant :
- un photodétecteur (PD) relié à un premier noeud (SN) de la cellule ;
- un transistor amplificateur (SF) ayant :
sa grille connectée au premier noeud,
un noeud de conduction relié à une sortie (250) de la cellule, et un noeud de commande d'une tension de grille arrière, le transistor amplificateur (SF) étant configuré pour que sa tension de seuil varie en fonction de la tension de grille arrière du transistor amplificateur (SF) ;
le circuit comprenant au moins un circuit d'asservissement configuré pour ajuster une tension appliquée au noeud de commande de la tension de grille arrière du transistor amplificateur (SF) d'une des cellules en fonction d'une tension (VX) présente à la sortie de la cellule et d'une tension de référence (VREF).

Fig. 2

## Description

Domaine technique

La présente description concerne de façon générale les circuits électroniques et notamment les capteurs d'images.

Technique antérieure

Les circuits électroniques des capteurs d'image comprennent, dans certains cas, des cellules d'acquisition d'images, appelées pixels, comportant une photodiode utilisée en inverse. Pour certains types de pixels, l'obtention du niveau d'éclairement reçu par un pixel passe par la mesure de la tension aux bornes de la photodiode, à des instants choisis. Lors d'une période d'acquisition, la tension aux bornes de la photodiode varie sous l'effet de l'intégration du courant photogénéré dans la capacité de la diode. La mesure de la tension aux bornes de la photodiode est réalisée après que le pixel a été réinitialisé. Cette réinitialisation induit un bruit aléatoire dont l'écart type vaut $\sqrt{\dfrac{kT}{C}}$ où k est la constante de Boltzmann, T la température et C la capacité de la photodiode.

Cependant, certains nouveaux matériaux photosensibles organiques pressentis pour remplacer les semiconducteurs classiquement utilisés ne permettent pas l'utilisation d'une diode pincée, et il convient donc d'utiliser des architectures de pixel différentes.

Il existe un regain d'intérêt pour les capteurs d'images ne comportant pas de grille de transfert. Ces architectures de pixels sont par exemple de type « 3T » avec trois transistors ou encore de type amplificateur à transimpédance capacitive (Capacitive Transimpedance Amplifier, CTIA en anglais). Ces architectures de pixel sont toutefois sujettes au bruit induit par la réinitialisation de la photodiode qui est généralement supérieur d'un facteur dix par rapport à toutes les autres sources de bruit.

Résumé de l'invention

Il existe un besoin d'obtenir des circuits électroniques comprenant des pixels où l'impact du bruit $\sqrt{\dfrac{kT}{C}}$ est diminué.

Un mode de réalisation pallie tout ou partie des inconvénients des circuits électroniques connus.

Un mode de réalisation prévoit un circuit électronique comprenant des cellules d'acquisition d'image, chaque cellule comportant :

- un photodétecteur relié à un premier noeud de la cellule ;
- un transistor amplificateur ayant :

  sa grille connectée au premier noeud, un noeud de conduction relié à une sortie de la cellule, et un noeud de commande d'une tension de grille arrière, le transistor amplificateur étant configuré pour que sa tension de seuil varie en fonction de la tension de grille arrière du transistor amplificateur ; le circuit comprenant au moins un circuit d'asservissement configuré pour ajuster une tension appliquée au noeud de commande de la tension de grille arrière du transistor amplificateur d'une des cellules en fonction d'une tension présente à la sortie de la cellule et d'une tension de référence.

Un mode de réalisation prévoit un procédé de commande d'un circuit électronique, le procédé comprenant :

- ajuster, par un circuit d'asservissement, en fonction d'une tension présente à une sortie d'une cellule d'acquisition d'image et d'une tension de référence, une tension appliquée à un noeud de commande d'une tension de grille arrière d'un transistor amplificateur de la cellule d'acquisition d'image du circuit électronique, ledit transistor amplificateur étant configuré pour que sa tension de seuil varie en fonction de ladite tension de grille arrière,

chaque cellule comportant :

- un photodétecteur relié à un premier noeud de la cellule, et
- ledit transistor amplificateur dont un noeud de conduction est relié à la sortie de la cellule et dont la grille est connectée au premier noeud.

Dans un mode de réalisation, ledit au moins un circuit d'asservissement est configuré pour ajuster une tension appliquée au noeud de commande de la tension de grille arrière du transistor amplificateur (SF, DRV) d'une des cellules en fonction, en même temps, d'une tension (VX) présente à la sortie de la cellule et d'une tension de référence (VREF).

Dans un mode de réalisation, le transistor amplificateur est formé dans une technologie utilisant un substrat semiconducteur déplété sur isolant.

Dans un mode de réalisation, chaque cellule comprend un condensateur d'échantillonnage et un transistor d'échantillonnage, le noeud de commande de la tension de grille arrière du transistor amplificateur de chaque cellule étant relié au condensateur d'échantillonnage et relié à une sortie du circuit d'asservissement par l'intermédiaire du transistor d'échantillonnage.

Dans un mode de réalisation, le condensateur d'échantillonnage stocke une valeur de correction échantillonnée de la sortie du circuit d'asservissement sur le noeud de commande de tension de grille arrière du transistor amplificateur.

Dans un mode de réalisation, la taille du condensateur d'échantillonnage est indépendante de la sensibilité de la cellule d'acquisition d'image.

Dans un mode de réalisation, le circuit d'asservissement comprend un amplificateur différentiel dont une première entrée est reliée à ladite sortie de la cellule, et dont une deuxième entrée est configurée pour recevoir la tension de référence, une sortie de l'amplificateur différentiel fournissant une tension de sortie, appliquée au transistor d'échantillonnage, et fonction d'un écart entre la tension présente à la sortie de la cellule et la tension de référence.

Dans un mode de réalisation, le premier noeud de chaque cellule est un noeud de détection et chaque cellule comprend :

- un transistor de lecture connecté en série avec le transistor amplificateur ; et
- un transistor de réinitialisation configuré pour relier le noeud de détection à un rail de tension de réinitialisation, le transistor amplificateur étant monté en source suiveuse et ayant ledit noeud de conduction relié à la sortie de la cellule par l'intermédiaire du transistor de lecture.

Dans un mode de réalisation, chaque cellule est de type à amplificateur à transimpédance capacitive et comprend :

- un transistor de lecture connecté en série avec le transistor amplificateur ;
- un transistor de réinitialisation configuré pour relier un noeud d'intégration, commun au transistor de lecture, au transistor amplificateur et au transistor de réinitialisation, au premier noeud ; et
- une capacité d'intégration reliant le noeud d'intégration et le premier noeud ;

le transistor amplificateur ayant ledit noeud de conduction relié à la sortie de la cellule par l'intermédiaire du transistor de lecture.

Dans un mode de réalisation, au moins certaines des cellules sont agencées en au moins une colonne de cellules, dans laquelle les sorties des cellules sont interconnectées par au moins un premier conducteur de colonne relié à une source de courant et à un premier circuit d'asservissement configuré pour ajuster séquentiellement une tension appliquée au noeud de commande de la tension de grille arrière du transistor amplificateur de chacune des cellules de la colonne.

Dans un mode de réalisation, le transistor amplificateur est isolé par des tranchées.

Dans un mode de réalisation, le condensateur d'échantillonnage a une capacité supérieure à celle du premier noeud associé ou de la capacité.

Dans un mode de réalisation, les photodétecteurs comprennent un matériau organique et/ou des nanoparticules.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A est un schéma-bloc d'un exemple de circuit électronique d'acquisition d'images ;

la figure 1B est une vue schématique d'un pixel de type « 3T » ;

la figure 1C est un chronogramme illustrant un exemple de fonctionnement du circuit de la figure 1B ;

la figure 2 est une vue schématique d'une matrice de cellules d'acquisition d'images d'un circuit électronique selon un mode de réalisation de la présente description ;

la figure 3 est un chronogramme illustrant un fonctionnement du circuit de la figure 2 ; et

la figure 4 est une vue schématique d'une matrice de cellules d'acquisition d'images d'un circuit électronique selon un mode de réalisation de la présente description.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

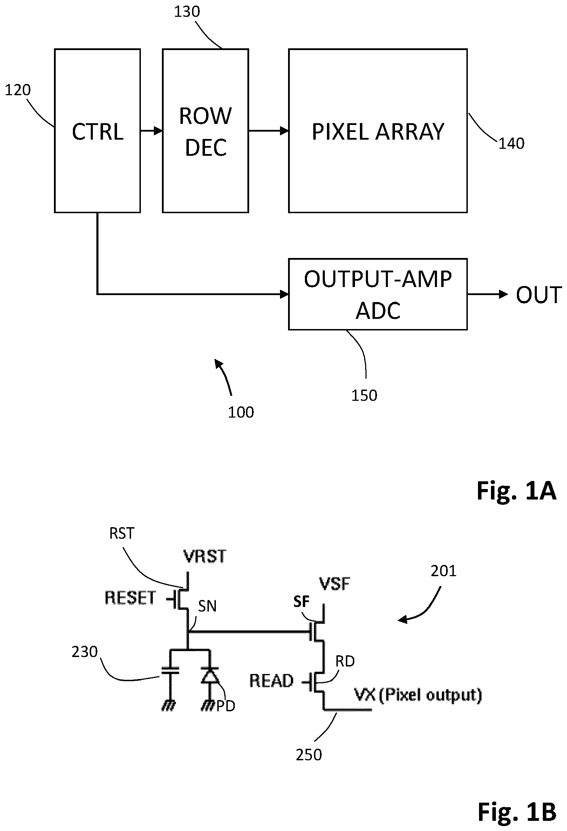

La figure 1A est un schéma-bloc d'un exemple de circuit électronique 100 d'acquisition d'images. Ce circuit comporte une matrice d'acquisition d'images 140 (PIXEL ARRAY) comportant un réseau matriciel de cellules d'acquisition d'image ou pixels à l'intersection de conducteurs de rangées et de conducteurs de colonnes. Le dispositif d'acquisition comporte également une unité de commande 120 (CTRL) pilotant, entre autres, un circuit 130 de décodage de lignes ou rangées (ROW DEC) et un circuit 150 d'amplificateurs de sortie (OUTPUT-AMP ADC) ou de convertisseurs analogique-numérique, généralement un par colonne, fournissant des signaux numériques OUT représentatifs de l'éclairement des différentes cellules. Ces signaux numériques sont exploités par un dispositif (non représenté) associé au circuit électronique d'acquisition d'images et comportant, par exemple, des circuits de mémorisation des valeurs affectées aux différentes cellules et de traitement d'images.

La figure 1B est une vue schématique d'un pixel 201 de type « 3T » (signifiant « 3 transistors »). Le pixel 201 comporte en effet trois transistors, un premier transistor RST, un deuxième transistor SF et un troisième transistor RD.

Dans l'exemple de la figure 1B, le pixel 201 comporte une photodiode PD référencée à la masse et reliée à un noeud de détection SN du pixel 201. La somme de toutes les capacités connectées à ce noeud de détection SN, c'est-à-dire la capacité de jonction de la photodiode, les capacités des transistors connectés et les capacités parasites, est représentée par la référence 230. La photodiode PD est utilisée en inverse et la capacité 230 est, après une réinitialisation, déchargée par un photocourant en fonction de l'intensité lumineuse reçue. La cathode de la photodiode est reliée au noeud SN.

Dans l'exemple de la figure 1B, le premier transistor RST est configuré pour relier le noeud de détection SN à un rail de tension de réinitialisation, par exemple alimenté par une tension VRST.

Dans l'exemple de la figure 1B, le deuxième transistor SF est monté en source suiveuse, et a sa grille connectée au noeud de détection SN et sa source reliée à une sortie 250 du pixel. Le drain du deuxième transistor SF est, par exemple, connecté à un rail d'alimentation d'un potentiel VSF, positif. Dans certains cas, les tensions VRST et VSF sont égales, bien que, dans d'autres exemples, ces tensions puissent être différentes l'une par rapport à l'autre.

Le premier transistor RST reçoit, sur sa grille, un signal RESET à deux états de commande de réinitialisation de la tension au noeud de détection SN. Lorsque le signal RESET est dans un premier état, le premier transistor RST est conducteur. Dans un second état du signal RESET, le transistor RST est bloqué.

Dans l'exemple de la figure 1B, le troisième transistor RD est connecté en série avec le deuxième transistor SF. Dans un exemple non illustré, le drain du deuxième transistor SF est relié, par le troisième transistor RD, au rail de tension d'alimentation VSF. Le troisième transistor RD est commandé par un signal READ de sélection de ligne ou rangée. Le troisième transistor RD agit comme un interrupteur permettant de polariser le transistor SF par exemple par une source de courant de colonne connectée à la sortie 250 du pixel 201. Lorsqu'il est polarisé, le transistor SF est un suiveur qui fait suivre le signal du noeud SN sur un noeud VX de la sortie 250 du pixel 201.

Le passage d'un état passant à non passant du troisième transistor RD induit un bruit aléatoire ayant un écart type $\sqrt{\dfrac{kT}{C}}$ au niveau du noeud SN, que le transistor SF fait suivre au niveau de la sortie du pixel VX.

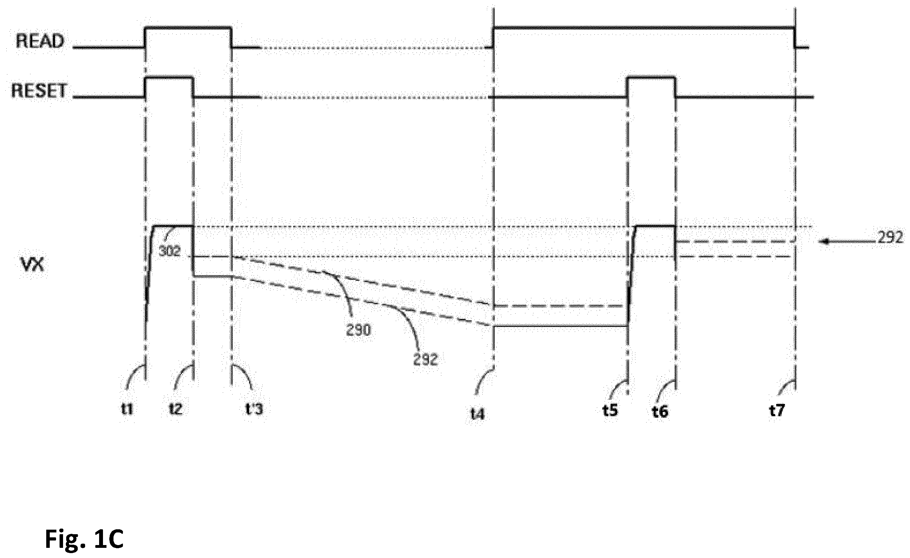

La figure 1C est un chronogramme illustrant un exemple de fonctionnement du circuit de la figure 1B.

A un temps t1, les signaux READ et RESET sont mis dans un état, par exemple haut, pour rendre les transistors RD et RST passants. Le noeud de détection SN est ainsi mis à la tension VRST et la tension VX se stabilise à un niveau 302 dépendant d'un décalage dû au dimensionnement du transistor SF et à la valeur du courant de colonne correspondant.

A un temps t2, le signal RESET est par exemple mis à un état bas pour rendre le transistor RST non passant. La capacité au niveau du noeud de détection SN est de l'ordre du femtofarad ce qui fait, qu'au temps t2, un bruit large bande $\sqrt{\dfrac{kT}{C}}$ est généré dans le canal du transistor RST puis échantillonné au niveau du noeud de détection SN et se retrouve, en bande de base, intégré à VX sous forme d'un décalage de tension aléatoire, illustré sur la courbe 292, par rapport au cas non bruité 290. Une phase d'intégration démarre à partir du temps t2, ce qui provoque la baisse (dans le cas où les charges sont des électrons) de la tension VX au fur et à mesure que les charges sont photogénérées jusqu'à un temps t5.

A un temps t'3 compris entre les temps t2 et t5, le signal READ passe, par exemple, à un état bas, pour rendre non-passant le transistor RD et pour permettre d'accéder à d'autres lignes de la matrice.

A un temps t4 compris entre les temps t'3 et t5, le signal READ passe, par exemple, à un niveau haut pour rendre le transistor RD passant jusqu'à un temps t7. Entre les temps t4 et t5, la tension VX est, par exemple, convertie par un convertisseur analogique numérique, non illustré sur la figure 1C, qui est relié à la sortie VX du pixel. Dans la figure 1C, les échelles de temps entre les temps t1 et t'3 et entre t4 et t7 ne sont pas les mêmes qu'entre t'3 et t4 de sorte que le temps relativement long entre t'3 et t4 puisse être représenté. De ce fait, bien que les pentes des courbes 290 et 292 entre t'3 et t4 apparaissent plus importantes qu'entre les temps t4 et t5, elles sont en réalité similaires.

Dans l'exemple de la figure 1C, une phase de deuxième échantillonnage corrélé ("Correlated Double Sampling" en anglais) a lieu entre le temps t6 et le temps t7 pour connaître la valeur de VX en l'absence de charges photogénérées. Pour ce faire, le signal RESET passe à un niveau haut au temps t5 jusqu'à un temps t6 où il repasse à un niveau bas. Entre les temps t5 et t6, la tension VX s'établit de nouveau au même niveau qu'entre les temps t1 et t2, au bruit aléatoire $\sqrt{\frac{kT}{C}}$ près. Au temps t6 et jusqu'au temps t7, on lit le pixel sans signal, ce qui correspond à une première numérisation du niveau de la tension VX. Les charges intégrées entre t6 et t7 peuvent être négligées car le temps d'intégration est court. Entre les temps t6 et t7, la tension VX est, par exemple, convertie, lors d'une deuxième numérisation, par le convertisseur analogique numérique utilisé pour la première phase d'intégration et la comparaison entre les valeurs obtenues lors des deux numérisations donne accès à la quantité de charges photogénérées. Cependant, le bruit aléatoire $\sqrt{\frac{kT}{C}}$ échantillonné sur la tension SN quand le transistor RST passe de l'état haut à l'état bas, est statistiquement différent entre la première et la deuxième numérisation. L'écart type de la différence devient donc $\sqrt{\frac{2kT}{C}}$ et ce bruit est dominant par rapport à toutes les autres sources de bruit, compte tenu de la valeur en général très faible de la capacité C du noeud de détection SN. Il est donc souhaitable de proposer une solution pour diminuer l'impact de ce bruit.

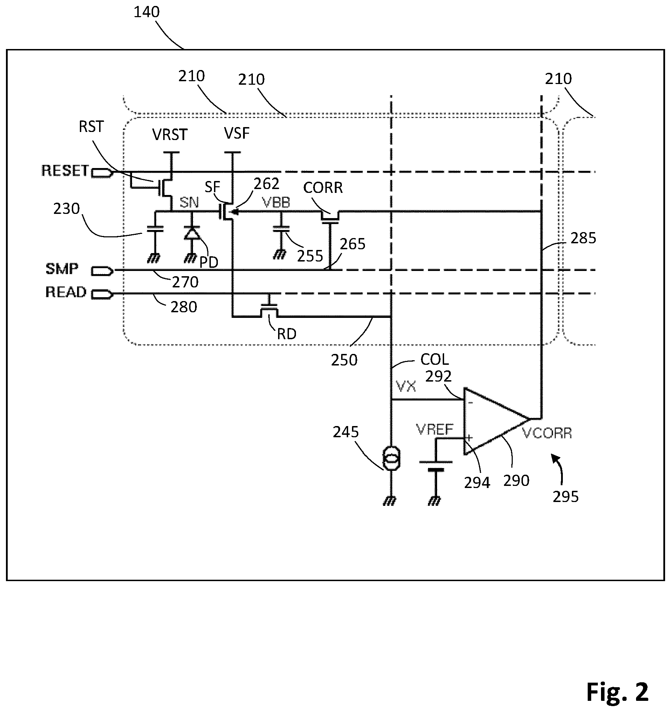

La figure 2 est une vue schématique d'une matrice 140 de cellules 210 d'acquisition d'images du circuit électronique selon un mode de réalisation de la présente description. Dans l'exemple de la figure 2, une seule cellule 210 est représentée pour une raison de clarté. Dans un exemple, au moins certaines des cellules 210 sont agencées en au moins une colonne de cellules, dans laquelle les cellules sont interconnectées par au moins un premier conducteur de colonne COL relié à une source de courant 245. Dans un exemple non illustré, au moins certaines des cellules 210 sont agencées en plusieurs colonnes de cellules et les cellules d'une même colonne sont interconnectées par au moins un conducteur de colonne, par exemple isolé du premier conducteur de colonne, et relié à une autre source de courant ou à la même source de courant 245.

Dans l'exemple de la figure 2, chaque cellule 210 comprend un pixel de type « 3T » comme décrit dans la Figure 1B. De façon différente de la figure 1B, dans la figure 2, le deuxième transistor SF de chaque cellule comprend en outre un noeud de commande 262 d'une tension de grille arrière VBB du deuxième transistor SF. Le deuxième transistor SF est par exemple configuré pour que sa tension de seuil varie en fonction de cette tension de grille arrière.

Le noeud de commande 262 correspond, par exemple, à une grille arrière du deuxième transistor SF. Dans ce cas, la grille connectée au noeud de détection SN est une grille dite « avant ». Les grilles arrière et avant peuvent agir de façon séparée, et avec une transconductance associée différente, sur un même canal du deuxième transistor SF. Les grilles arrière peuvent être formées, par exemple, par la technologie utilisant un substrat semiconducteur déplété, de préférence complètement déplété, sur isolant (Fully Depleted Silicon on Insulator en anglais, FDSOI). Lorsque le substrat du deuxième transistor SF est de type FDSOI, la grille arrière est, par exemple, formée sous une couche d'isolant placée entre le canal et le substrat. Dans cet exemple, la grille avant est, par exemple, formée en surface au-dessus de l'isolant et du canal.

Dans un autre exemple, le noeud de commande 262 correspond à une électrode influençant la tension de seuil du canal réalisé dans le matériau semiconducteur du substrat du deuxième transistor SF. Par exemple, des portions du matériau semiconducteur comportant ladite électrode sont isolées du reste du substrat par des tranchées isolantes par exemple polarisées.

Dans l'exemple de la figure 2, la source du deuxième transistor SF de chaque cellule d'une même colonne est reliée, par le troisième transistor RD, au conducteur de colonne COL de la matrice 140. Le troisième transistor RD est commandé par un signal READ de sélection de ligne ou rangée, fourni par exemple, sur une ligne de commande 280 commune à toutes les cellules 210 d'une même rangée. Le transistor RD fait suivre l'information de tension du noeud SN, qui arrive à la sortie 250 de la cellule 210, au conducteur de colonne COL d'une même colonne avec une valeur VX.

Dans l'exemple de la figure 2, les sorties 250 des cellules d'une même colonne sont, par exemple, interconnectées par un même conducteur de colonne COL.

Dans l'exemple de la Figure 2, le circuit comprend au moins un premier circuit d'asservissement 295 ayant une entrée reliée à la sortie 250 des cellules 210 d'une même colonne et ayant une sortie reliée au noeud de commande 262 de la tension de grille arrière du deuxième transistor SF des cellules 210 de la même colonne par l'intermédiaire d'un autre conducteur de colonne 285 et par l'intermédiaire d'un transistor d'échantillonnage CORR compris dans chaque pixel.

Le circuit d'asservissement 295 est, par exemple, configuré pour ajuster une tension VBB appliquée au noeud de commande de la tension de grille arrière du deuxième transistor SF en fonction d'un asservissement de la tension VX présente à la sortie 250 de la cellule sélectionnée sur le signal READ pour qu'elle tende vers une tension de référence VREF.

Dans l'exemple de la figure 2, le circuit d'asservissement 295 comprend un amplificateur différentiel 290, dont une première entrée 292 est reliée à ladite sortie 250 de la cellule, et dont une deuxième entrée 294 est configurée pour recevoir la tension de référence VREF. L'amplificateur différentiel 290 a, par exemple, une sortie configurée pour fournir une tension de sortie VCORR, qui est fonction du niveau d'asservissement appliqué à la tension VX pour que la tension VX tende vers la tension de référence VREF. Dans un exemple, la tension VREF est choisie pour être à un niveau moyen des tensions présentes aux noeuds de stockage SN des cellules 210 de la colonne auxquelles est soustraite la tension grille-source du deuxième transistor SF.

Le circuit d'asservissement 295 applique la correction VCORR à la cellule sélectionnée par le transistor RD par l'intermédiaire du transistor d'échantillonnage CORR de la même cellule.

Dans l'exemple de la figure 2, chaque cellule 210 comprend un condensateur de stockage 255 référencé à la masse et le transistor d'échantillonnage CORR. Le noeud de commande 262 de la tension de grille arrière du deuxième transistor SF de la cellule est connecté au condensateur de stockage 255 et connecté à la sortie de l'amplificateur différentiel 290 par l'intermédiaire du transistor d'échantillonnage CORR. Un des noeuds de conduction principale du transistor d'échantillonnage CORR de chaque cellule d'une même colonne est relié à la sortie du circuit d'asservissement 295. Dans un exemple, le condensateur de stockage 255 a une capacité supérieure à la capacité du noeud de détection SN ce qui permet, par exemple, de réduire l'injection de charge lors de l'échantillonnage par le transistor CORR et de favoriser la rétention de la tension d'asservissement VBB sans avoir d'impact sur le facteur de conversion (en Volt/électron) du pixel.

Le transistor d'échantillonnage CORR reçoit, sur sa grille, un signal SMP à deux états de commande définissant des plages de temps dans lesquelles respectivement 1) la sortie de l'amplificateur 290 est reliée au noeud de commande 262 de la tension de grille arrière du transistor SF, et 2) dans lesquelles le transistor d'échantillonnage CORR est bloqué et la tension VCORR est donc échantillonnée et stockée par le condensateur 255. La rétention de la tension VCORR est d'autant meilleure que la capacité de stockage 255 est connectée sur la grille arrière du transistor CORR, car le gain entre la grille arrière et la source est d'environ 10%, contre environ 90% pour la grille avant. Le fait d'avoir une capacité importante limite donc la dérive de tension due aux courants de fuite, et de plus, cette dérive de tension est fortement atténuée par le faible gain entre la grille arrière 262 et la source du transistor SF. La tension VBB de commande du noeud 262 correspond à la tension VCORR de sortie de l'amplificateur 290, échantillonnée par le transistor d'échantillonnage CORR et stockée par la capacité 255.

La valeur d'asservissement qui se retrouve dans la tension VBB échantillonnée sur la capacité 255 échantillonne également un bruit en $\sqrt{\frac{kT}{C1}}$ où « C1 » est ici la valeur de la capacité d'échantillonnage 255. Néanmoins, la capacité d'échantillonnage 255 étant plus grande que la capacité du noeud de détection SN, le bruit généré est plus faible. De plus, la tension VBB échantillonnée étant stockée sur la grille arrière 262, son bruit associé est multiplié par l'amplification de la grille arrière (soit environ 10%), sachant que le bruit principal à corriger du noeud de détection SN subit l'amplification d'environ 90% de la grille avant. En comparant ces deux contributions sur le noeud VX, la contribution au bruit total à la sortie 250 amenée par la correction sur la grille arrière 262 est très inférieure à celle du bruit à corriger sur le noeud de détection SN par exemple d'un rapport 1/10.

Le signal SMP est, par exemple, commun à toutes les cellules d'une même rangée et est fourni, par exemple, sur une ligne de rangée 270.

En fonctionnement, l'amplificateur 290 fournit la tension VCORR pour rendre la tension VX de sortie de la cellule sélectionnée égale à la tension de référence VREF.

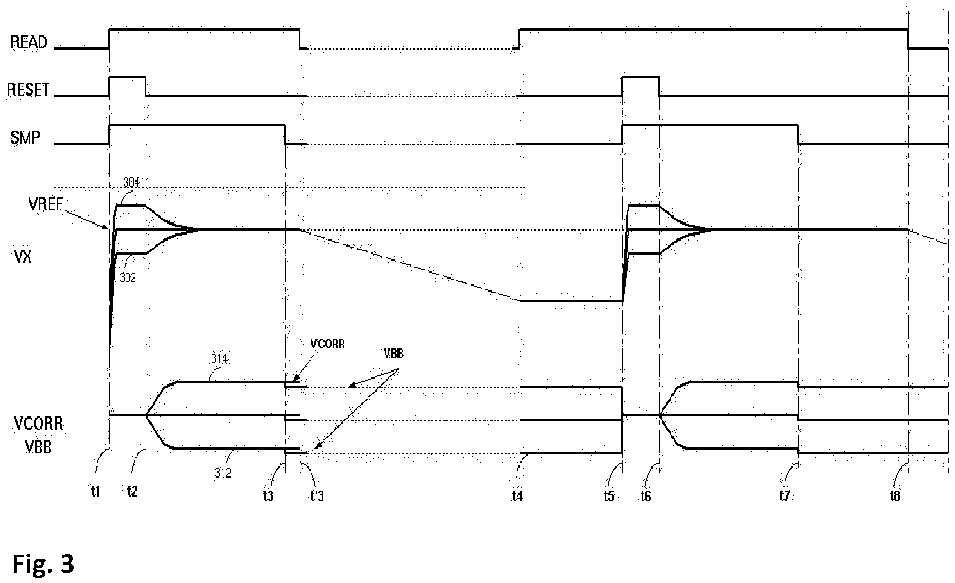

La figure 3 est un chronogramme illustrant un fonctionnement du circuit de la figure 2.

A un temps t1, similaire au temps t2 de la figure 1C, les signaux READ, RESET et SMP sont mis dans un état, par exemple haut, pour rendre les transistors RD, RST et CORR passants. Les cellules 210 de la rangée à lire sont alors sélectionnées. Le noeud de détection SN est ainsi mis à la tension VRST et la tension VX se stabilise à un niveau dépendant d'un décalage 302, 304 dû aux disparités de dimensionnement du transistor SF entre les cellules.

A un temps t2, le signal RESET est par exemple mis à un état bas pour rendre le transistor RST non passant. Au temps t2, le bruit $\sqrt{\frac{kT}{C}}$ généré dans le canal du transistor RST est échantillonné au niveau de la sortie du pixel et se retrouve intégré à VX sous forme d'un décalage de tension.

A un temps t3, l'amplificateur 290, qui a par exemple été activé au préalable avant le temps t2, fournit à sa sortie la tension VCORR générée sur la base d'une comparaison entre la tension VX initialement bruitée et la tension VREF. Le bruit est échantillonné au temps t2, ce qui fixe l'entrée de l'amplificateur, qui a ensuite besoin d'un certain temps (jusqu'à t3) pour se stabiliser. Le niveau de la tension VCORR ainsi obtenue dépend de la tension sur le noeud de détection SN comprenant à la fois les décalages dus aux différences de dimensionnement des transistors SF et au bruit $\sqrt{\frac{kT}{C}}$. La tension VCORR viendra modifier la tension de seuil du deuxième transistor SF de la cellule sélectionnée qui, en retour, modifiera la tension de sortie de la cellule VX en formant une boucle d'asservissement pour que VX tende vers VREF.

Au temps t3, la sortie de l'amplificateur étant stabilisée à la valeur de correction, le signal SMP est mis, par exemple, à un niveau bas pour rendre le transistor d'échantillonnage CORR non-passant et l'amplificateur 290 est, par exemple, désactivé. La capacité d'échantillonnage 255 de la correction prend alors le relais en stockant la tension d'asservissement pendant toute la durée de l'intégration qui commence après l'échantillonnage.

Comme représenté sur l'exemple de la figure 3, au temps t3, une injection de charges peut avoir lieu au niveau du noeud de commande 262, et se traduire par une variation de la tension VCORR. Il existe en outre une autre injection de charges, beaucoup plus importante, apparaissant au moment du front descendant du signal RESET. La personne du métier mettra en oeuvre des précautions pour limiter ces injections de charges et pourra, à cette fin, mettre en oeuvre un procédé de double échantillonnage corrélé (Correlated double sampling, CDS en anglais).

Le niveau de sortie VX obtenu pendant l'établissement et l'échantillonnage de la correction est principalement déterministe puisque la partie aléatoire correspondant au bruit $\sqrt{\frac{kT}{C}}$ a été corrigée.

Au temps t'3, similaire au temps t'3 de la figure 1C, le signal READ passe, par exemple à un état bas, pour rendre non-passant le transistor de sélection RD.

De façon similaire à la figure 1C, la première phase d'intégration démarre à partir du temps t2 ce qui provoque la baisse (dans le cas où les charges sont des électrons) de la tension VX au fur et à mesure que les charges sont photogénérées jusqu'au temps t5 similaire à la figure 1C.

Au temps t4 compris entre les temps t'3 et t5 et similaire au temps t4 de la figure 1C, le signal READ passe, par exemple, à un niveau haut pour rendre le transistor RD passant jusqu'au temps t8 similaire au temps t8 de la figure 1C. Entre les temps t4 et t5, la tension VX est, par exemple, convertie par un convertisseur analogique numérique, non illustré sur la figure 3, qui est relié à la sortie VX du pixel.

Dans la figure 3, les échelles de temps entre les temps t1 et t'3 et entre t4 et t8 ne sont pas les mêmes qu'entre t'3 et t4 de sorte que le temps relativement long entre t'3 et t4 puisse être représenté. De ce fait, bien que la pente de la courbe de la tension VX entre t'3 et t4 apparaisse plus importante qu'entre les temps t4 et t5, elle est en réalité similaire.

Le circuit électronique et son fonctionnement, tels que décrits dans l'exemple de la figure 2 et 3, permettent de corriger, en gardant une certaine rapidité, en alignant la tension VX de sortie de la cellule sur la tension de référence VREF, le bruit thermique aléatoire intrinsèque aux montages « 3T ». Une problématique similaire pourra être appliquée aux montages « CTIA ».

De façon similaire à la figure 1C, la phase de deuxième échantillonnage corrélé a lieu entre les temps t7 et t8 pour appliquer la valeur de réinitialisation, avant la phase d'intégration, et en tenant compte de la correction de bruit kT/C.

Au temps t5, après la conversion du signal avec le convertisseur analogique numérique, les signaux RESET et SMP repassent à un niveau haut pour rendre passants respectivement les transistors RST et CORR, et effectuer une nouvelle opération d'asservissement du bruit $\sqrt{\frac{kT}{c}}$ avec le circuit d'asservissement 295.

Au temps t6 similaire au temps t6 de la figure 1C, le signal RESET passe, par exemple, à un niveau bas pour rendre le transistor RST non passant. Une nouvelle valeur de bruit $\sqrt{\frac{kT}{c}}$ est alors échantillonnée sur le noeud de détection. Avant le temps t6 ou à t6 l'amplificateur est, par exemple, réactivé pour asservir la tension VX de sortie de la cellule à la tension VREF comme entre t2 et t3. Le niveau de sortie VX obtenu en fin d'établissement, à un temps t7, et l'échantillonnage de la correction est alors déterministe et égal à celui obtenu au temps t3 de par l'élimination de la partie aléatoire $\sqrt{\frac{kT}{c}}$.

A la fin du temps d'établissement, au temps t7, compris entre les temps t6 et t8, le signal SMP passe, par exemple, à un niveau bas pour rendre le transistor d'échantillonnage CORR non-passant ce qui permet de stocker la correction VBB à appliquer sur la capacité 255. Entre les temps t7 et t8, une conversion analogique numérique de la tension VX, non illustrée, est alors réalisée ce qui permet de mesurer VX en l'absence de charges photogénérées et avec correction du bruit $\sqrt{\frac{kT}{c}}$. Par différence entre la première conversion (entre t4 et t5) et la deuxième conversion (entre t7 et t8), la fonction de double échantillonnage corrélé (CDS) fournit uniquement le résultat de l'intégration de charges photogénérées, la partie aléatoire $\sqrt{\frac{kT}{c}}$ ayant été corrigée.

Par comparaison, pendant le même passage à l'état haut du signal READ entre la valeur de VX, obtenue entre t7 et t8, et la valeur de VX, obtenue entre t4 et t5, c'est-à-dire après la phase d'intégration, il est possible de mesurer une quantité plus précise des charges accumulées sans stockage mémoire. Les mêmes éléments (cellule 210, amplificateur 295, tensions de commande, etc.) étant utilisés entre les temps t2 à t3, puis entre les temps t6 et t7, les disparités entrant en jeu sont les mêmes, si bien que leurs effets vont se compenser exactement par l'opération de double échantillonnage corrélé.

La phase du fonctionnement du circuit électronique comprise entre les temps t5 et t8 permet de s'affranchir des dispersions de dimensionnement des transistors entre les cellules (Fixed Pattern Noise en anglais) notamment en ce qui concerne les disparités entre les transistors CORR et/ou deuxièmes transistors SF des différentes cellules 210 des différentes colonnes.

En résumé, avant la première numérisation la boucle d'asservissement permet de diviser, par le gain de la boucle, la somme du décalage déterministe dû aux différences lors de la fabrication et du premier bruit aléatoire généré $\sqrt{\dfrac{kT}{c}}$ . De même, avant la deuxième numérisation, la boucle d'asservissement 295 permet de corriger la somme du décalage déterministe dû aux différences lors de la fabrication et du deuxième bruit aléatoire généré $\sqrt{\dfrac{kT}{c}}$ .

La différence entre les deux numérisations correspond au signal dû aux charges photogénérées.

Le double échantillonnage corrélé (CDS) permet de faire la différence entre les deux numérisations pour obtenir les charges photogénérées.

La personne de l'art pourra néanmoins mettre en oeuvre une mesure des charges photogénérées sans double échantillonnage corrélé au prix toutefois d'une plus faible précision. En effet, le double échantillonnage corrélé permet de corriger notamment l'offset de l'amplificateur 290 et l'injection de charges lors de l'échantillonnage au niveau de VBB.

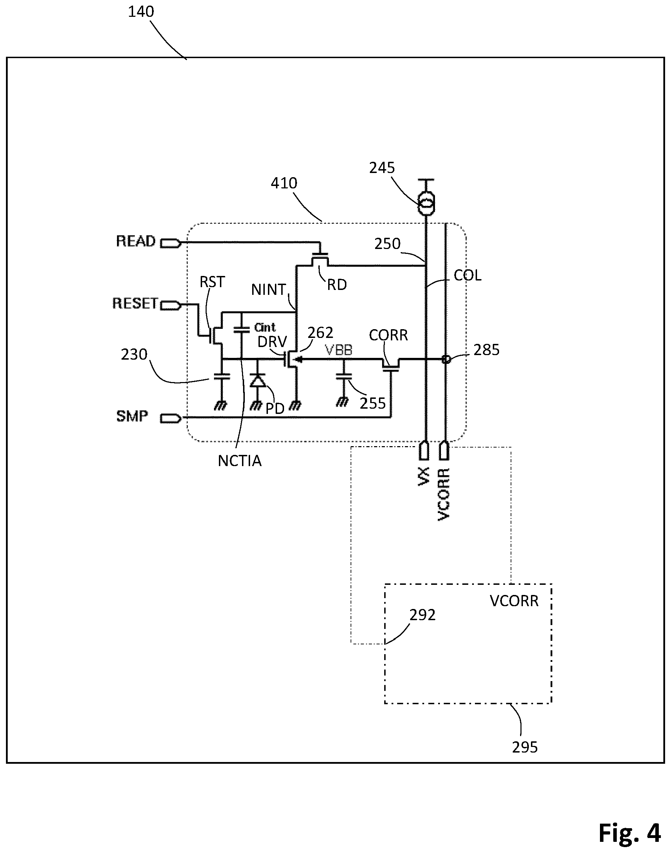

La figure 4 est une vue schématique d'une matrice 140 de cellules 410 d'acquisition d'images d'un circuit électronique selon un mode de réalisation de la présente description. Dans l'exemple de la figure 4, seule une cellule 410 est représentée pour des raisons de clarté mais plusieurs cellules 410 sont par exemple agencées en colonne et en rangées de façon similaire aux cellules 210 de la figure 2.

Les cellules 410 de la figure 4 reprennent des éléments similaires à ceux des cellules 210 de la figure 2 à l'exception du fait que les cellules 410 comprennent chacune un pixel de type CTIA et non pas un transistor de type « 3T ».

Dans l'exemple de la figure 4, le pixel CTIA de la cellule 410 comporte une photodiode PD référencée à la masse et reliée à un noeud d'entrée NCTIA du CTIA. La somme de toutes les capacités connectées au noeud d'entrée NCTIA, c'est-à-dire la capacité de jonction de la photodiode, les capacités des transistors connectés et les capacités parasites, est représentée par la référence 230. La photodiode PD est utilisée en inverse et le photocourant généré s'intègre dans une capacité d'intégration Cint reliant le noeud SN au noeud NCTIA. La cathode de la photodiode est reliée au noeud NCTIA.

Dans l'exemple de la figure 4, le pixel CTIA de la cellule 410 comporte un premier transistor RST configuré pour relier le noeud d'entrée NCTIA à un noeud de détection SN commun à des transistors RD et DRV. Le transistor RST reçoit, sur sa grille, un signal RESET à deux états de commande de réinitialisation de la tension au noeud d'entrée NCTIA. Lorsque le signal RESET est dans un premier état, le transistor RST est conducteur ce qui réinitialise la charge de Cint. Dans un second état du signal RESET, le transistor RST est bloqué ce qui permet l'intégration des charges photogénérées dans Cint.

Dans l'exemple de la figure 4, le transistor DRV, monté en source commune, a sa grille connectée au noeud d'entrée NCTIA et son drain relié au noeud d'intégration NINT.

Dans l'exemple de la figure 4, la cellule 410 comprend un transistor RD connecté en série avec le drain du transistor DRV au niveau du noeud commun NCTIA. Le drain du transistor DRV est relié, par le troisième transistor RD, au conducteur de colonne COL connecté à une source de courant 245. Le transistor RD est commandé par un signal READ de sélection de ligne ou rangée.

Lorsque la cellule 410 est polarisée, c'est-à-dire lorsque le signal READ est à 1, le potentiel du noeud NCTIA est égal à la tension grille-source du transistor DRV polarisé par le courant issu de la source de courant 245. Lorsque le signal RESET est à 1, la tension aux bornes de Cint vaut 0V. Lorsque le signal RESET est à 0, les charges photogénérées s'intègrent dans la capacité de rétroaction Cint. Le signal est donc détecté au noeud d'intégration NINT.

Dans l'exemple de la figure 4, et de façon similaire à la figure 2, le transistor DRV de chaque cellule 410 comprend en outre un noeud de commande 262 d'une tension de grille arrière VBB du transistor DRV. Le transistor DRV est configuré, comme pour la figure 2, pour que sa tension de seuil varie en fonction de cette tension de grille arrière.

Dans l'exemple de la figure 4, le circuit comprend au moins un premier circuit d'asservissement 295, similaire au circuit d'asservissement 295 de la figure 2, et ayant une entrée reliée à la sortie 250 des cellules 410 d'une même colonne et ayant une sortie reliée au noeud de commande 262 de la tension de grille arrière du deuxième transistor SF des cellules 410 de la même colonne par l'intermédiaire d'un autre conducteur de colonne 285. La correction s'applique à une cellule donnée lorsque le transistor d'échantillonnage correspondant CORR est passant, et que la ligne de la cellule est sélectionnée avec READ=1. Le circuit d'asservissement 295 de la figure 4 étant similaire à celui de la figure 2 seules l'entrée 292 et la sortie VCORR sont représentées. Le circuit d'asservissement 295 de la figure 4 est configuré pour ajuster une tension VBB, qui est la tension VCORR qui sera échantillonnée, appliquée au noeud de commande 262 de la tension de grille arrière du transistor DRV en fonction d'une comparaison entre la tension VX présente à la sortie 250 de la cellule sélectionnée avec le signal READ et la tension de référence VREF.

L'exemple de la figure 4, de façon similaire à l'exemple de la figure 2, permet de stocker une correction de la tension de seuil sur la grille arrière du transistor DRV monté en source commune, afin de corriger l'offset vu sur le rail VX. La personne du métier saura réaliser l'asservissement de la tension de grille arrière VBB, d'une manière similaire à celle présentée en détail dans l'exemple de la figure 2.

Le fonctionnement de l'exemple de la figure 4 est par exemple similaire à l'exemple de la figure 3 sauf que la tension VX entre t2 et t6 augmente au lieu de diminuer lors de l'intégration du signal.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

En particulier, dans les exemples des figures 2 ou 4, la capacité du condensateur 255 peut être choisie grande, par rapport par exemple à celle du noeud de détection SN ou de la capacité Cint pour favoriser la rétention indépendamment de la capacité du noeud de détection SN pour la figure 2 ou de la capacité Cint de la figure 4. En d'autres termes, la taille du condensateur d'échantillonnage 255 est indépendante de la sensibilité de la cellule 210, 410 d'acquisition d'image.

En particulier, même si les modes de réalisation présentés sont basés sur la photo génération d'électrons, la personne du métier pourra mettre en oeuvre ses connaissances pour modifier les circuits présentés dans le cas où des trous sont générés au niveau du noeud de détection SN.

D'autre part, même si le cas de photodiodes a été décrit dans les différents modes de réalisation, la personne du métier pourra les remplacer par des photodétecteurs comprenant un matériau organique et/ou des nanoparticules.

**Revendications**

1. Circuit électronique comprenant des cellules (210, 410) d'acquisition d'image,

    chaque cellule comportant :

        - un photodétecteur (PD) relié à un premier noeud (SN,NCTIA) de la cellule ;
        - un transistor amplificateur (SF, DRV) ayant :

            sa grille connectée au premier noeud, un noeud de conduction relié à une sortie (250) de la cellule, et un noeud de commande d'une tension de grille arrière, le transistor amplificateur (SF,DRV) étant configuré pour que sa tension de seuil varie en fonction de la tension de grille arrière du transistor amplificateur (SF,DRV) ;

    le circuit comprenant au moins un circuit d'asservissement configuré pour ajuster une tension appliquée au noeud de commande de la tension de grille arrière du transistor amplificateur (SF, DRV) d'une des cellules en fonction d'une tension (VX) présente à la sortie de la cellule et d'une tension de référence (VREF).

2. Procédé de commande d'un circuit électronique, le procédé comprenant :

    - ajuster, par un circuit d'asservissement, en fonction d'une tension (VX) présente à une sortie (250) d'une cellule d'acquisition d'image (210, 410) et d'une tension de référence (VREF), une tension appliquée à un noeud de commande d'une tension de grille arrière d'un transistor amplificateur (SF,DRV) de la cellule d'acquisition d'image (210, 410) du circuit électronique, ledit transistor amplificateur étant configuré pour que sa tension de seuil varie en fonction de ladite tension de grille arrière,

    chaque cellule comportant :

        - un photodétecteur (PD) relié à un premier noeud (SN,NCTIA) de la cellule, et
        - ledit transistor amplificateur (SF,DRV) dont un noeud de conduction est relié à la sortie (250) de la cellule et dont la grille est connectée au premier noeud.

3. Circuit selon la revendication 1, ou méthode selon la revendication 2, dans lequel ledit au moins un circuit d'asservissement est configuré pour ajuster une tension appliquée au noeud de commande de la tension de grille arrière du transistor amplificateur (SF, DRV) d'une des cellules en fonction, en même temps, d'une tension (VX) présente à la sortie de la cellule et d'une tension de référence (VREF).

**4.** Circuit selon la revendication 1 ou 3, ou procédé selon la revendication 2 ou 3, dans lequel le transistor amplificateur (SF,DRV) est formé dans une technologie utilisant un substrat semiconducteur déplété sur isolant.

**5.** Circuit selon l'une quelconque des revendications 1 ou 3 ou 4, ou procédé selon l'une quelconque des revendications 2 à 4, dans lequel chaque cellule (210, 410) comprend un condensateur d'échantillonnage (255) et un transistor d'échantillonnage (CORR), le noeud de commande (262) de la tension de grille arrière du transistor amplificateur (SF,DRV) de chaque cellule étant relié au condensateur d'échantillonnage (255) et relié à une sortie du circuit d'asservissement (295) par l'intermédiaire du transistor d'échantillonnage (CORR).

**6.** Circuit ou procédé selon la revendication 5, dans lequel le condensateur d'échantillonnage (255) stocke une valeur de correction (VBB) échantillonnée de la sortie du circuit d'asservissement (295) sur le noeud de commande de tension de grille arrière du transistor amplificateur (SF,DRV).

**7.** Circuit ou procédé selon la revendication 5 ou 6, dans lequel la taille du condensateur d'échantillonnage (255) est indépendante de la sensibilité de la cellule (210, 410) d'acquisition d'image.

**8.** Circuit ou procédé selon l'une quelconque des revendications 5 à 7, dans lequel le circuit d'asservissement (295) comprend un amplificateur différentiel (290) dont une première entrée (292) est reliée à ladite sortie (250) de la cellule, et dont une deuxième entrée est configurée pour recevoir la tension de référence (VREF), une sortie de l'amplificateur différentiel (290) fournissant une tension de sortie (VCORR), appliquée au transistor d'échantillonnage (CORR), et fonction d'un écart entre la tension (VX) présente à la sortie de la cellule et la tension de référence (VREF).

**9.** Circuit électronique selon l'une quelconque des revendications 1, 3 à 8, ou procédé selon l'une quelconque des revendications 2 à 8, le premier noeud de chaque cellule étant un noeud de détection (SN) et chaque cellule comprenant :

- un transistor de lecture (RD) connecté en série avec le transistor amplificateur (SF) ; et
- un transistor de réinitialisation (RST) configuré pour relier le noeud de détection (SN) à un rail de tension de réinitialisation,

le transistor amplificateur (SF) étant monté en source suiveuse et ayant ledit noeud de conduction relié à la sortie (250) de la cellule par l'intermédiaire du transistor de lecture (RD).

**10.** Circuit électronique selon l'une quelconque des revendications 1, 3 à 8, ou procédé selon l'une quelconque des revendications 2 à 8, chaque cellule étant de type à amplificateur à transimpédance capacitive (CTIA) et comprenant :

- un transistor de lecture (RD) connecté en série avec le transistor amplificateur (DRV) ;
- un transistor de réinitialisation (RST) configuré pour relier un noeud d'intégration (NINT), commun au transistor de lecture (RD), au transistor amplificateur (DRV) et au transistor de réinitialisation (RST), au premier noeud (NCTIA) ; et
- une capacité d'intégration (Cint) reliant le noeud d'intégration (NINT) et le premier noeud (NCTIA) ;

le transistor amplificateur (DRV) ayant ledit noeud de conduction relié à la sortie (250) de la cellule par l'intermédiaire du transistor de lecture (RD).

**11.** Circuit selon l'une quelconque des revendications 1, 3 à 10, ou procédé selon la revendication 2 à 10, dans lequel au moins certaines des cellules sont agencées en au moins une colonne de cellules, dans laquelle les sorties (250) des cellules sont interconnectées par au moins un premier conducteur de colonne (COL) relié à une source de courant (245) et à un premier circuit d'asservissement configuré pour ajuster séquentiellement une tension appliquée au noeud de commande de la tension de grille arrière du transistor amplificateur (SF, DRV) de chacune des cellules de la colonne.

**12.** Circuit selon l'une quelconque des revendications 1 ou 5 à 11 dans leur dépendance à la revendication 1, ou procédé selon l'une quelconque des revendications 2 ou 5 à 11 dans leur dépendance à la revendication 1, dans lequel le transistor amplificateur (SF,DRV) est isolé par des tranchées.

**13.** Circuit électronique ou procédé selon l'une quelconque des revendications 10 à 12 dans leur dépendance à la revendication 5, dans lequel le condensateur d'échantillonnage (255) a une capacité supérieure à celle du premier noeud associé (SN) ou de la capacité (Cint).

**14.** Circuit selon l'une quelconque des revendications 1, 3 à 13 ou procédé selon l'une quelconque des revendications 2 à 13, dans lequel les photodétecteurs comprennent un matériau organique et/ou des nanoparticules.

130

120

CTRL → ROW DEC → PIXEL ARRAY — 140

CTRL → OUTPUT-AMP ADC → OUT

150

100

**Fig. 1A**

RST

VRST

RESET — SN

230

PD

VSF

SF

201

READ — RD

VX (Pixel output)

250

**Fig. 1B**

Fig. 1C

Fig. 2

**Fig. 3**

Fig. 4

| | Europäisches Patentamt |
|---|---|
| | European Patent Office |
| | Office européen des brevets |

# RAPPORT DE RECHERCHE EUROPEENNE

**Numéro de la demande**

EP 24 16 5291

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2021/195126 A1 (PALMIGIANI GAELLE [FR]) 24 juin 2021 (2021-06-24) | 1,2,5-7, 9,10,12, 14 | INV. H04N25/63 H04N25/65 |
| Y | * alinéas [0060] - [0063]; figure 1 * | 4,11,13 | H04N25/77 |
| A | * alinéa [0066] * * alinéas [0080] - [0083]; figure 4 * * alinéas [0098] - [0101]; figure 7 * * alinéa [0106]; figure 10 * * alinéa [0109]; figure 13 * * figure 14 * | 3,8 | H04N25/771 |
| | ----- | | |
| Y | US 2017/324385 A1 (MCKAY THOMAS G [US]) 9 novembre 2017 (2017-11-09) * alinéas [0039] - [0042]; figure 4 * | 4 | |
| | ----- | | |
| Y | US 6 532 040 B1 (KOZLOWSKI LESTER J [US] ET AL) 11 mars 2003 (2003-03-11) * colonne 7, ligne 57 - colonne 9, ligne 5; figure 3 * | 11,13 | |
| | ----- | | |

**DOMAINES TECHNIQUES RECHERCHES (IPC)**

H04N

Le présent rapport a été établi pour toutes les revendications

| Lieu de la recherche | Date d'achèvement de la recherche | Examinateur |
|---|---|---|
| Munich | 18 juillet 2024 | Berne, Jean-François |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P04C02)

**EP 4 440 136 A1**

**ANNEXE AU RAPPORT DE RECHERCHE EUROPEENNE
RELATIF A LA DEMANDE DE BREVET EUROPEEN NO.**

EP 24 16 5291

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-07-2024

| Document brevet cité au rapport de recherche | Date de publication | Membre(s) de la famille de brevet(s) | | Date de publication |
|---|---|---|---|---|
| US 2021195126 A1 | 24-06-2021 | CN | 113099142 A | 09-07-2021 |
| | | EP | 3840365 A1 | 23-06-2021 |
| | | EP | 4167587 A1 | 19-04-2023 |
| | | FR | 3105576 A1 | 25-06-2021 |
| | | IL | 279456 A | 30-06-2021 |
| | | US | 2021195126 A1 | 24-06-2021 |
| | | US | 2024089624 A1 | 14-03-2024 |
| US 2017324385 A1 | 09-11-2017 | CN | 107452798 A | 08-12-2017 |
| | | TW | 201812951 A | 01-04-2018 |
| | | US | 2017324385 A1 | 09-11-2017 |
| US 6532040 B1 | 11-03-2003 | US | 6532040 B1 | 11-03-2003 |
| | | WO | 0014950 A1 | 16-03-2000 |

EPO FORM P0460

Pour tout renseignement concernant cette annexe : voir Journal Officiel de l'Office européen des brevets, No.12/82